Europäisches Patentamt

European Patent Office

Office européen des brevets

(19)

(11) Veröffentlichungsnummer: **0 400 183**
**A1**

## (12) EUROPÄISCHE PATENTANMELDUNG

(21) Anmeldenummer: **89109870.9**

(22) Anmeldetag: **31.05.89**

(51) Int. Cl.5: **G11C 29/00, G11C 11/40**

(43) Veröffentlichungstag der Anmeldung:
**05.12.90 Patentblatt 90/49**

(84) Benannte Vertragsstaaten:
**AT DE FR GB IT NL**

(71) Anmelder: **Siemens Aktiengesellschaft**
**Wittelsbacherplatz 2**
**D-8000 München 2(DE)**

(72) Erfinder: **Kantz, Dieter, Dipl.-Ing.**
**Heiglhofstrasse 45**
**D-8000 München 70(DE)**

(54) **Bewerterschaltung eines integrierten Halbleiterspeichers vom Typ DRAM.**

(57) Die Bewerterschaltung AMPL enthält erfindungsgemäß eine Multiplex-Einrichtung MUXN,MUXP. Damit sind ihr, gesteuert über wenigstens ein Taktsignal $\emptyset$, $\overline{\emptyset}$, wahlweise entweder übliche Bewerterpotentiale VSS,VDD oder frei wählbare elektrische Potentiale VXN,VXP zuführbar. Dies ermöglicht eine Analyse der Bewerterschaltung AMPL ohne Veränderung von Versorgungsspannungen des Halbleiterspeichers sowie der Pegelwerte und des Timings von Eingangssignalen des gesamten Halbleiterspeichers. Es wird auch ein entsprechendes Betriebsverfahren vorgestellt.

FIG 2

EP 0 400 183 A1

## Bewerterschaltung eines integrierten Halbleiterspeichers vom Typ DRAM

Die Erfindung betrifft eine Bewerterschaltung eines integrierten Halbleiterspeichers nach dem Oberbegriff des Patentanspruches 1 sowie ein Verfahren zum Betrieb eines integrierten Halbleiterspeichers nach dem Oberbegriff des Patentanspruches 6.

Gattungsgemäße Bewerterschaltungen sind beispielsweise aus EP-A 0 056 434 und aus "IEEE Journal of Solid-State Circuits, Vol. SC-20, No. 5, October 1985, Seiten 903 bis 908 bekannt.

Beiden Ausführungsformen (reine NMOS-Schaltung und CMOS-Schaltung) ist gemeinsam, daß sie als dynamische Flip-Flops mit kreuzgekoppelten Transistoren gestaltet sind und daß sie durch Zuführen von Bewerterpotentialen in ihrer Funktion gesteuert werden.

Für den wirtschaftlichen Erfolg integrierter Halbleiterspeicher sind ihre technischen Eigenschaften ein entscheidender Punkt. Von zentraler Bedeutung sind dabei der Arbeitsbereich der Bewerterschaltungen sowie die Minimalwerte der Lesesignale, die die Bewerterschaltungen gerade noch fehlerfrei verarbeiten können. Diese Parameter sind stark abhängig von einer technisch gleichen Wirkung und Symmetrie der verwendeten Transistoren. Sie werden üblicherweise im Entwicklungsstadium sowie bei Qualifizierungstests mittels Variation von Betriebsspannungen sowie von Pegeln und Timing von Eingangssignalen gewonnen. Diese Methode verändert jedoch das Zeitverhalten der speicherintern ablaufenden Signale sowie die Potentialverhältnisse im gesamten Halbleiterspeicher, so daß die Meßergebnisse nicht mehr eindeutig einzelnen Fehlerquellen und dem Arbeitsbereich der Bewerterschaltungen selbst zuzuordnen sind.

Aufgabe der vorliegenden Erfindung ist es, eine gattungsgemäße Bewerterschaltung so weiterzubilden, daß eine Ermittlung ihres Arbeitsbereiches sowie einzelner Fehlerquellen möglich ist, ohne dabei die sonstigen elektrischen und zeitlichen Verhältnisse des Halbleiterspeichers selbst zu beeinflussen. Weiterhin ist es Aufgabe, bekannte Betriebsverfahren so zu modifizieren, daß die obengenannten Ermittlungen möglich sind.

Diese Aufgabe wird gelöst durch die kennzeichnenden Merkmale der Patentansprüche 1 und 6. Vorteilhafte Aus- und Weiterbildungen sind in Unteransprüchen gekennzeichnet.

Die Erfindung wird im folgenden anhand von FIG näher erläutert.

Es zeigen:

FIG 1 eine bekannte Bewerterschaltung in einem Halbleiterspeicher,

FIG 2 und 3 die erfindungsgemäße Bewerterschaltung und eine bevorzugte Ausführungsform,

FIG 4 ein zugehöriges Impulsdiagramm.

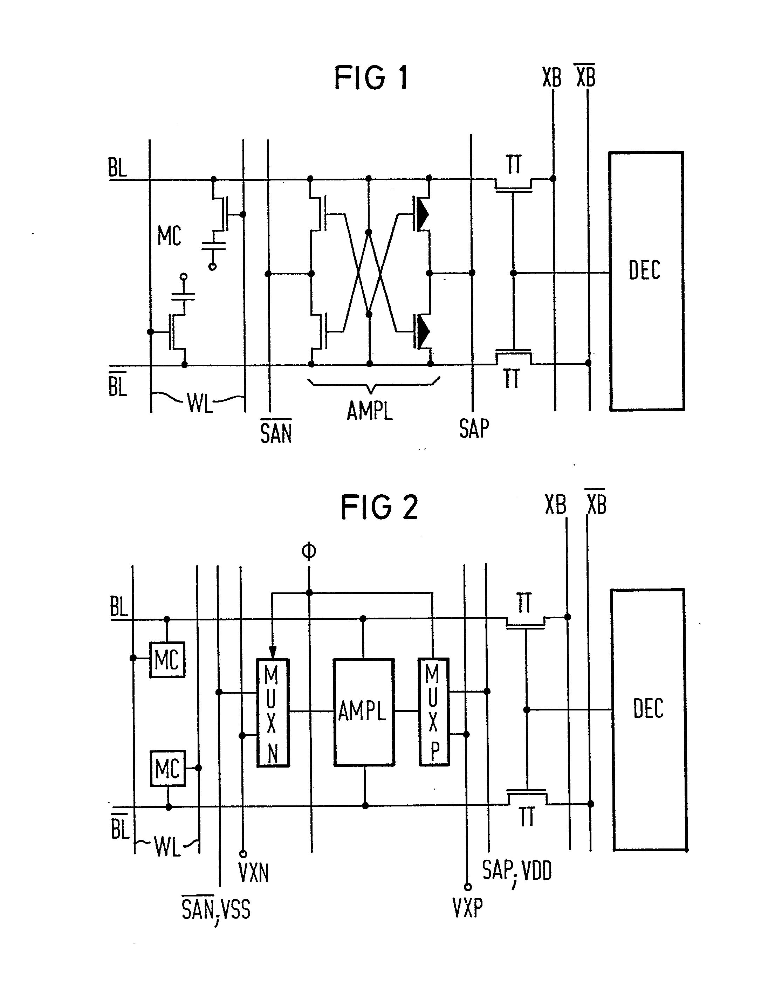

FIG 1 zeigt eine bekannte Bewerterschaltung AMPL in einem ausschnittsweise dargestellten integrierten Halbleiterspeicher (Speicherzellen MC, Bitleitungen BL und $\overline{BL}$ (allgemein als Referenzbitleitung bezeichnet), Wortleitungen WL, Transfertransistoren TT (auch als Bitschalter bezeichnet) mit Adreßdekoder DEC sowie externe Bitleitungen XB, $\overline{XB}$ ). Weiterhin sind zwei Steuersignale $\overline{SAN}$ und SAP dargestellt zur Bereitstellung von Bewerterpotentialen VSS,VDD. Letztere weisen meist die gleichen Werte auf wie die Versorgungspotentiale VSS,VDD des gesamten integrierten Halbleiterspeichers. Sie steuern in bekannter Weise die Bewerterschaltungen AMPL.

Die in FIG 2 dargestellte Erfindung weist gegenüber der bekannten Bewerterschaltung zusätzlich eine Multiplex-Einrichtung (dargestellt in zwei Teileinheiten) MUXN,MUXP, ein Taktsignal Ø und wertemäßig frei wählbare elektrische Potentiale VXN,VXP auf. Diese sind in einem Normalbetrieb ohne Einfluß auf die Bewerterschaltung AMPL. In einem Testbetrieb, der beispielsweise der Ermittlung der eingangs genannten Parameter dient, weist das Taktsignal Ø einen zeitlichen Verlauf auf, der bewirkt, daß zunächst über die Steuersignale $\overline{SAN}$. SAP die Bewerterpotentiale VSS,VDD an der Bewerterschaltung AMPL anliegen und daß anschließend über die Multiplex-Einrichtung MUXN,MUXP anstelle der Bewerterpotentiale VSS,VDD die frei wählbaren elektrischen Potentiale VXN,VXP an der Bewerterschaltung AMPL anliegen. Mit der erfindungsgemäßen Anordnung ist folgendes Testverfahren durchführbar:

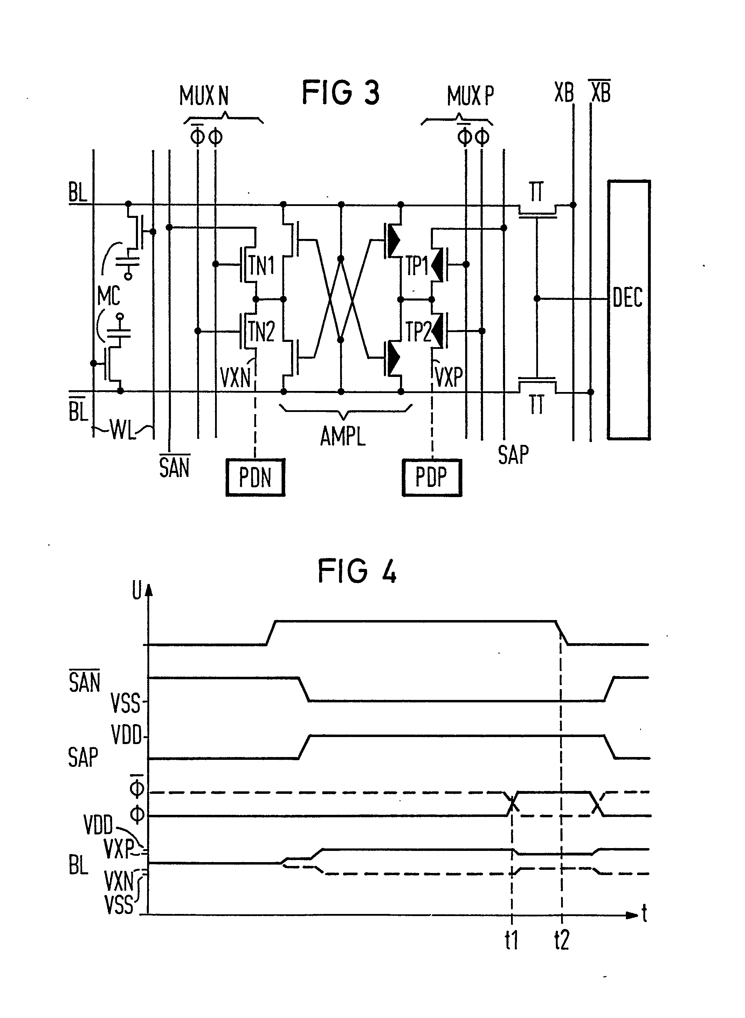

Bei einem mit üblichen Einschreibverfahren unter Verwendung der Bewerterpotentiale VSS.VDD beschriebenen Halbleiterspeicher, dessen Speicherzellen MC demzufolge die Daten eines gewählten (beliebigen) Prüfmusters enthalten, werden die gespeicherten Daten von Speicherzellen MC entlang einer Wortleitung WL mittels der Taktsignale $\overline{SAN}$,SAP und der Bewerterpotentiale VSS, VDD auf die zugehörigen Bewerterschaltungen AMPL ausgelesen und bewertet (in FIG 4 dargestellt im Zeitabschnitt bis zum Zeitpunkt t1). Dabei können die Taktsignale $\overline{SAN}$,SAP selbst die Bewerterpotentiale VSS,VDD als logische Pegel aufweisen. Jeder Lesezyklus beinhält bekanntlich auch einen an das Lesen und Bewerten sich anschließenden Zeitabschnitt, in dem die so gewonnenen Daten wieder in die Speicherzellen MC zurückgeschrieben werden (beispielsweise benützt im sog. Refresh-Modus). Dieser Zeitabschnitt wird nun mittels der vorteilhaften Anordnung im erfindungsgemäßen Verfahren folgendermaßen modifiziert (vgl.

Zeitraum t1 bis t2 in FIG 4):

Das Taktsignal Ø bzw. zwei zueinander komplementäre Taktsignale Ø, Ø̄ (vgl. FIG 3) werden aktiviert. Dadurch liegen nun über die Multiplex-Einrichtung MUXN,MUXP anstelle der Bewerterpotentiale VSS,VDD die frei wählbaren Potentiale VXN,VXP an jeder Bewerterschaltung AMPL an. Demzufolge werden die ausgelesenen und bewerteten Daten nicht mit den Pegeln der Bewerterpotentiale VSS,VDD in die Speicherzellen MC zurückgeschrieben, sondern mit den Pegeln der frei wählbaren elektrischen Potentiale VXN,VXP. Weist beispielsweise das eine frei wählbare elektrische Potential VXN einen Wert auf, der 200 mV über dem Wert des Bewerterpotentials VSS liegt, so werden ausgelesene Daten "log. 0" mit einem Potentialwert zurückgeschrieben, der 200 mV über dem Wert des einen Bewerterpotentials VSS liegt (gestrichelt dargestellt in FIG 4). Entsprechendes gilt für ausgelesene Daten "log. 1" (in FIG 4 dargestellt mittels einer durchgezogenen Linie): Weist das andere frei wählbare elektrische Potential VXP einen Wert auf, der beispielsweise 500 mV unter dem Wert des anderen Bewerterpotentials VDD liegt, so werden ausgelesene Daten "log. 1" mit einem Potentialwert zurückgeschrieben, der 500 mV unter dem Wert des anderen Bewerterpotentials VDD liegt. Der gesamte Auslese- und Rückschreibvorgang kann beispielsweise ein (abgesehen von der Verwendung der frei wählbaren elektrischen Potentiale VXN,VXP) üblicher Refresh-Zyklus sein.

Die erfindungsgemäße Anordnung bewirkt in Verbindung mit dem beschriebenen Auslese-/Rückschreibevorgang, daß bei einem späteren Ausleseverfahren die in den Speicherzellen MC gespeicherten Daten nicht, wie sonst üblich, mit den den Bewerterpotentialen VSS,VDD entsprechenden Pegeln zur Bewertung an den Bewerterschaltungen AMPL anliegen, sondern mit modifizierten Pegeln, die den Werten der frei wählbaren elektrischen Potentiale VXN,VXP entsprechen. Es lassen sich somit Potentialgrenzwerte für die zu speichernden Daten ermitteln, bei denen der integrierte Halbleiterspeicher bzw. einzelne Speicherzellen MC und Bewerterschaltungen AMPL (bei Anwendung der sog. Bit-Map-Analyse) gerade noch funktionieren.

Es ist vorteilhaft, wenn die frei wählbaren elektrischen Potentiale VXN,VXP halbleiterspeicher-intern über Potentialgeneratoren erzeugbar sind. Weiterhin ist es vorteilhaft, wenn die elektrischen Potentiale VXN,VXP dem Halbleiterspeicher über sog. Hilfspads PDN,PDP baustein-extern zuführbar sind.

Es ist auch vorteilhaft, die frei wählbaren elektrischen Potentiale VXN,VXP im Halbleiterspeicher vorhandenen, den frei wählbaren Potentialen VXN,VXP zugeordneten, Leiterbahnen mittels Prüfspitzen baustein-extern zuzuführen. In den beiden letzten Fällen ist der Halbleiterspeicher nach seiner Montage in ein Gehäuse vor unberechtigten Manipulationen durch Dritte geschützt.

Es ist auch günstig, anstelle eines einzigen Taktsignales Ø zwei Taktsignale Ø, Ø̄ mit einem zueinander komplementären zeitlichen Verlauf vorzusehen, wie in FIG 3 gezeigt.

Vorteilhaft ist es auch, wenn die Multiplex-Einrichtung MUXN, MUXP n-Kanal- und p-Kanal-Transistoren enthält.

FIG 3 zeigt eine vorzugsweise zu verwendende Ausführungsform: Es sind außer den üblichen Elementen (z.B. Speicherzellen MC, Wortleitungen WL, Bewerterschaltungen AMPL, Transfertransistoren TT, Steuersignale S̄ĀN̄,SAP mit den Bewerterpotentialen VSS, VDD) eine Multiplex-Einrichtung MUXN,MUXP, zueinander komplementäre Taktsignale Ø, Ø̄ und Hilfspads PDN,PDP zur Zuführung der frei wählbaren Potentiale VXN,VXP vorgesehen. Die eine Teileinrichtung MUXN der Multiplex-Einrichtung MUXN,MUXP enthält in Serie geschaltete n-Kanal-Transistoren TN1,TN2. Die andere Teileinrichtung MUXP der Multiplex-Einrichtung MUXN,MUXP enthält in Serie geschaltete p-Kanal-Transistoren TP1,TP2. Ihre Verbindungspunkte sind jeweils mit der Bewerterschaltung AMPL verbunden. Die Sources der einen Transistoren TN1,TP1 sind jeweils mit einem der Bewerterpotentiale VSS,VDD verbindbar. Die Sources der anderen Transistoren TN2,TP2 sind jeweils mit einem der Hilfspads PDN,PDP mit den frei wählbaren elektrischen Potentialen VXN,VXP verbunden. Die Gates der Transistoren TN1 und TP2 werden durch das Taktsignal Ø angesteuert. Die Gates der Transistoren TN2 und TP1 werden durch das dazu komplementäre Taktsignal Ø̄ angesteuert. Gemäß dem Zeitdiagramm nach FIG 4 sind im ersten Zeitabschnitt (d.h. bis zum Zeitpunkt t1) die einen Transistoren TN1 und TP1 leitend und die anderen Transistoren TN2,TP2 gesperrt, wodurch die Bewerterpotentiale VSS,VDD mittels der Steuersignale S̄ĀN̄,SAP an die Bewerterschaltung AMPL gelangen. Entsprechend sind im Zeitabschnitt von t1 bis t2 die anderen Transistoren TN2 und TP2 leitend und die einen Transistoren TN1,TP1 gesperrt, wodurch die frei wählbaren elektrischen Potentiale VXN,VXP an die Bewerterschaltung AMPL gelangen und somit an die Bitleitungen BL bzw. B̄L̄ . Dabei ist es weiterhin vorteilhaft, daß mindestens im Zeitraum zwischen t1 und t2 die Transfertransistoren TT gesperrt sind, so daß die externen Bitleitungen XB, X̄B̄ ohne Einfluß auf die (internen) Bitleitungen BL, B̄L̄ sind (d.h. die Dekoder DEG sind abgeschaltet). Dies ist beispielsweise der Fall im sog. RAS-Only-Betrieb oder im Refresh-Betrieb.

Bei dem erfindungsgemäßen Verfahren und der erfindungsgemäßen Anordnung ist es auch vorteilhaft, wenn die wertemäßig frei wählbaren Potentiale VXN,VXP unabhängig und getrennt voneinander einstellbar sind.

## Ansprüche

1. Bewerterschaltung eines integrierten Halbleiterspeichers vom Typ DRAM mit einer gesteuerten Zuführung von Bewerterpotentialen (VSS,VDD) an die Bewerterschaltung (AMPL), **dadurch gekennzeichnet,** daß wenigstens eine Multiplex-Einrichtung (MUXN,MUXP) vorgesehen ist zur wahlweisen, über wenigstens ein Taktsignal (∅, ∅̄) steuerbaren, Zuführung der Bewerterpotentiale (VSS,VDD) an die Bewerterschaltung (AMPL) oder von wertemäßig frei wählbaren elektrischen Potentialen (VXN, VXP.)

2. Bewerterschaltung nach Anspruch 1, **dadurch gekennzeichnet,** daß die frei wählbaren elektrischen Potentiale (VXN,VXP) im Halbleiterspeicher selbst erzeugbar sind.

3. Bewerterschaltung nach Anspruch 1, **dadurch gekennzeichnet,** daß die frei wählbaren elektrischen Potentiale (VXN,VXP) dem Halbleiterspeicher extern zuführbar sind.

4. Bewerterschaltung nach einem der vorhergehenden Ansprüche, **dadurch gekennzeichnet,** daß das Taktsignal (∅, ∅̄) aufgeteilt ist in zwei Signale mit einem zueinander komplementären zeitlichen Verlauf.

5. Bewerterschaltung nach einem der vorhergehenden Ansprüche, **dadurch gekennzeichnet,** daß die Multiplex-Einrichtung (MUXN,MUXP) n-Kanal- und p-Kanal-Transistoren (TN1, TN2;TP1,TP2) enthält.

6. Verfahren zum Betrieb eines integrierten Halbleiterspeichers vom Typ DRAM unter Verwendung von Bewerterpotentialen (VSS,VDD), **dadurch gekennzeichnet,** daß in Speicherzellen (MC) eingeschriebene Daten auf Bewerterschaltungen (AMPL) ausgelesen und in einem Testbetrieb mit gegenüber den Bewerter potentialen (VSS,VDD) differierenden Potentialen (VXN,VXP) in die Speicherzellen (MC) zurückgeschrieben werden, so daß sich bei einem erneuten Auslesen gegenüber einem die Bewerterpotentiale (VSS,VDD) beim Zurückschreiben verwendenden Normalbetrieb geänderte Lesesignale an den Bewerterschaltungen (AMPL) ergeben.

7. Verfahren nach Anspruch 6, **dadurch gekennzeichnet,** daß die differierenden Potentiale (VXN,VXP) wertemäßig frei wählbar sind.

8. Verfahren nach Anspruch 6 oder 7, **dadurch gekennzeichnet,** daß die differierenden Potentiale (VXN,VXP) unabhängig voneinander einstellbar sind.

# FIG 1

# FIG 2

# FIG 3

MUX N

$\overline{\Phi}\,\Phi$

MUX P

$\overline{\Phi}\,\Phi$

XB  $\overline{XB}$

BL

TN1

TP1

TT

MC

DEC

TN2

TP2

VXN

VXP

$\overline{BL}$

TT

WL

AMPL

$\overline{SAN}$

PDN

PDP

SAP

# FIG 4

U

$\overline{SAN}$

VSS

SAP

VDD

$\overline{\Phi}$

$\Phi$

VDD

VXP

BL

VXN

VSS

t

t1   t2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 080 935 (FUJITSU LTD) <br> * Seite 8, Zeile 7 - Seite 9, Zeile 37; Figuren 6-9 * <br><br> --- | 1 | G 11 C 29/00 <br> G 11 C 11/40 |
| A | IEEE JOURNAL OF SOLID STATE CIRCUITS, Heft 21, Nr. 5, Oktober 1986, Seiten 643-647, New York, US; S. FUJII et al.: "A 50-muA standby 1Mx1/256Kx4 CMOS DRAM with high-speed sense amplifier" <br> * Das ganze Artikel * <br><br> --- | 1 | |
| A | IEEE JOURNAL OF SOLID STATE CIRCUITS, Heft 10, Nr. 5, Oktober 1975, Seiten 255-261; R.C. FOSS et al.: "Peripheral circuits for one-transistor cell MOS RAM's" <br> * Seite 258, rechte Spalte, Zeile 16 - Seite 261, linke Spalte, Zeile 45; Figuren 6-9 * <br><br> ----- | 1 | |

**RECHERCHIERTE SACHGEBIETE (Int. Cl.5)**

G 11 C 29/00
G 11 C 11/40
G 11 C 11/41
G 11 C 7/06

Der vorliegende Recherchenbericht wurde für alle Patentansprüche erstellt

| Recherchenort | Abschlußdatum der Recherche | Prüfer |
|---|---|---|
| DEN HAAG | 13-02-1990 | DEGRAEVE L.W.G. |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus andern Gründen angeführtes Dokument
........................................................
& : Mitglied der gleichen Patentfamilie, übereinstimmendes
   Dokument